# NEW EUROPEAN PATENT SPECIFICATION

(11) **EP 0 272 019 B2**
(45) Date of publication and mention of the opposition decision: **18.08.1999**
(45) Mention of the grant of the patent: 16.03.1994
(21) Application number: 87310624.9
(22) Date of filing: 02.12.1987
(51) Int. Cl.: G03F 7/00

(54) **Image forming method and recording medium**
Aufzeichnungsverfahren und -Medium
Matériau et méthode pour l'enregistrement d'images

(30) Priority: 02.12.1986 JP 28707686
(43) Date of publication of application: 22.06.1988
(73) Proprietor: CANON KABUSHIKI KAISHA, Tokyo (JP)
(72) Inventor: Inui, Toshiharu, Yokohama-shi Kanagawa-ken (JP); Ohkuma, Norio, Machida-shi Tokyo (JP); Takenouchi, Masanori, Atsugi-shi Kanagawa-ken (JP); Miyagawa, Masashi, Yokohama-shi Kanagawa-ken (JP)
(74) Representative: Beresford, Keith Denis Lewis

(56) References cited:
- EP-A- 0 205 083
- FR-A- 2 434 412
- US-A- 4 535 050

## Description

This invention relates to an image forming method which performs image formation with photoenergy and heat energy and to a recording medium to be used for said method.

There have been known various methods in the art for forming images by photopolymerization or heat transfer. As the method for forming plates or images by photopolymerization, as disclosed in Japanese patent Publication Nos. 18979/1962 and 9672/1963, there is a method in which a photopolymerizable composition is provided on a support, imagewise exposure is effected to form a polymerized or unpolymerized image, and the image is transferred onto another support by utilizing the difference in tackiness or transferability obtained as the result.

Also, there is a method as disclosed in Japanese Patent Publication No. 8436/1964, in which after imagewise exposure of a photopolymerizable composition sandwiched between a support and a covering sheet, the support is separated from the covering sheet to obtain an image.

Further, there has been proposed a transfer imaging method for producing a multi-color image by using a color precursor (chromagenic material) and a developer (U.S. Patent No. 4,399,209). More specifically,in this method, an imaging sheet comprising a substrate and a coating thereon comprising a chromogenic material and a radiation curable composition encapsulated in rupturable capsule, is provided; the coating is subjected to imagewise exposure with actinic radiation to cure the radiation curable composition and form a latent image; and the latent image is superposed onto a latent image; and the latent image is superposed onto a developer sheet comprising a developer layer to form a visible image on the developer sheet..

Also, U.S. Patent 4,416,966 discloses a self-contained image forming system as shown in Fig. 12 in which a developer exists on the surface of the same support 1 together with the photosensitive microcapsules. In this system, after exposure primarily to UV-ray exchanged corresponding to a recording image, the microcapsules 3 are broken by passing the image formed sheet through pressure rolls to release the internal phase in a fashion to construct an image. At that time, the color forming agents are migrated to the developer usually provided within another layer 2, and in that portion the color forming agents undergo the reaction to form a multi-color image.

On the other hand, the heat transfer recording method has been developed with rapid development of information industries in recent years, and this performs recording on a recording paper by use of an ink ribbon comprising a ribbon-shaped support coated with a heat-fusible ink comprising a colorant dispersed in a heat-fusible binder.

More specifically, the above ink ribbon is superposed on a recording paper so that its heat transferable ink layer may contact the recording paper, said ink ribbon and the recording paper are conveyed to between the thermal head and the platen, and heat in pulses corresponding to image signals is applied by the thermal head from the support side of the above ink ribbon, and also both are pressure contacted to have the molten ink transferred onto the recording paper, whereby an ink image corresponding to the heat application is recorded on the recording paper.

The device using the above recording method has small size and light weight without noise, and further can effect recording on plain paper, and therefore it has been widely utilized in recent years.

Also, Japanese Patent Publication No. 9663/1963 discloses a method in which a photosensitive layer which causes reaction such as photopolymerization, photocrosslinking, etc. upon photoirradiation is sandwiched between a support and a film, and after light exposure thereon through a manuscript the support is separated from the film to form recorded images on the support and the film. This recording method utilizes reversal of the adhesive force of the photosensitive layer to the support and the adhesive force to the film before and after exposure, and the recorded image on the support and that on the film are in the negative-positive relationship.

According to "Kobunshi (Polymer)" Vol. 29, July (1980), a system utilizing the recording method similar to Japanese Patent Publication No. 9663/1963 is commercially sold from Du Pont Co. in USA.

According to the above literature "Kobunshi (Polymer)", p. 553, this system comprises a photosensitive layer coated on a polyester base subjected to surface coarsening treatment and a cover film attached on the photosensitive layer, in which the adhesive force between the support and the photosensitive layer is designed to be greater than the adhesive force between the cover film and the photosensitive layer. By exposure of the system through a manuscript to UV-ray from the cover film side, the photosensitive layer is polymerized, with the result that the adhesive force between the cover film and the photosensitive layer is increased. Accordingly, when the cover film is peeled off from the support, the photosensitive layer at the unexposed portion is adhered onto the support and the exposed portion is adhered onto the cover film, whereby positive image and negative image are obtained respectively (positive process). Also, by image exposure from the support side, followed subsequently by the whole surface exposure from the cover film side, a negative image can be obtained on the support (negative process).

However, the methods of the prior art as described above are not without problem. First, as the common problem in the image forming methods by use of photopolymerization, since the means used for image formation are all primarily UV-ray, that is, image is formed only by irradiation of a photoenergy on the recording medium, it is necessary to use a light-sensitive material with high sensitivity to the light or irradiate a light with high energy for performing sharp image formation at high speed.

However, in the case of a recording medium of high sensitivity by utilizing only photoreaction, there has been the vital defect that sensitivity at non-photoirradiation is also high and therefore storability at around room temperature is bad. Also, because the device for obtaining a high energy light is large in scale, when assembled as the image forming device, said device becomes larger in scale, and also the device cost becomes greater as undesirable in practical application.

Also, for obtaining a recording quality of high resolution according to the image forming method by use of photopolymerization, a positive film for exposure must be prepared. Besides, a positive film is prepared according to such method as silver salt photography, etc., and therefore there have been problems that the working steps become complicated, and also the device becomes larger in scale, thus consuming both time and expenses.

Further, the method for image formation only by use of photoenergy is not suitable for the case when images are outputted corresponding to the signals from the outside such as printer, etc. or the case when the image information is imparted to the recording medium after conversion of image reading from a color manuscript to digital signals by a color image scanner such as color-copying machine.

Also, the recording medium used in the image forming method disclosed particularly in U.S. Patents 4,399,209 and 4,416,966 has the drawback that the recorded image is essentially poor in stability, because a leuco dye is used as the developing method.

Further, in the image forming method in which color formation is effected by breaking of microcapsules, for making development by pressurization after exposure easy, the matter included within the microcapsules is required to be a photosensitive composition which is in liquid phase at normal temperature, and for this reason, it is poor in stability, and further the image obtained has existing monomer odor because of destruction of unreacted materials as undesirable on practical application.

On the other hand, in the heat transfer recording method, particularly when a multi-color image is desired to be obtained, colors are required to be superposed on one another by repeating transfer.

Accordingly, a plural number of thermal heads must be provided or the recording paper is required to undergo complicated movements such as stopping, reverse delivery, etc., whereby there are problems such that not only color slippage cannot be avoided, but also the device as a whole becomes greater and complicated, etc.

Accordingly, the present Applicants have proposed a method for performing transfer recording on paper, etc. by use of a plurality of energies (U.S. Serial No. 869,689 filed on June 2, 1986) as the recording method which cancels the drawbacks of the prior art as described above, and further proposed a recording method which has improved this recording method with respect to fixing (U.S. Serial No. 927,876 filed on November 7, 1986).

Also, the present Applicants have proposed a recording method utilizing a vaporizable dye (U.S. Serial No. 70,194 filed on July 6, 1987) in the recording method of the above U.S. Serial No. 869,689 filed on June 2, 1986).

An object of the present invention is to provide an image forming method which can effect image formation with digital signals with good storability, and yet require no superposion of colors by repeating transfer even in the case of forming a multi-color recorded image.

According to an aspect of the present invention, there is provided an image forming method as defined in claim 1.

According to another aspect of the present invention, there is provided an image forming method which further comprises transferring the above recorded image formed on the above first support or the above second support onto a transfer-receiving medium.
Fig. 1 is a side view of an example of a recording medium;
Fig. 2 is a diagrammatic illustration of the image forming method of the present invention;
Fig. 3 is a diagrammatic illustration of another example of the image forming method of the present invention;
Fig. 4 is a side view of another example of the recording medium;
Fig. 5A - Fig. 5D are diagrammatic illustrations of the image forming method of the present invention for performing multi-color recording;
Fig. 6A - 6D are diagrammatic illustrations of the principle of the image forming method of the present invention;
Fig. 7 is a schematic illustration showing an example of the device for practicing the image forming method of the present invention;
Fig. 8 is a graph showing the absorption characteristics of photoinitiators;
Fig. 9 is a sectional view showing the device used in Example 3;
Fig. 10 is a diagrammatic illustration of the driving timing chart; and
Fig. 11 is a side view showing an example of the recording medium of the prior art.

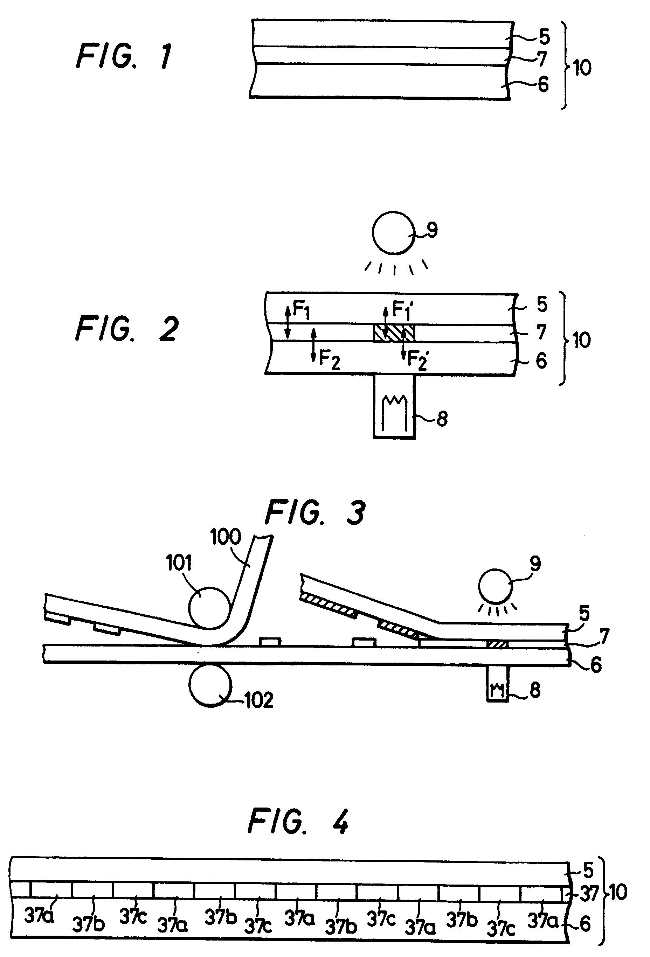

Fig. 1 illustrates an example of a recording medium in which 5 is a first support, 6 a second support and 7 an image forming layer. The image forming layer 7 is sandwiched between the support 5 and the support 6. When a photoenergy is imparted by the photoirradiation means 9 or a heat energy by the heating means 8 to the image forming layer 7 as shown in Fig. 2, only the portion of the image forming layer to which both the photoenergy and the heat energy are imparted (the portion hatched in Fig. 2; hereinafter the cured portion is shown by hatching) is cured.

For the first support 5 and the second support 6, the same material or different materials may be employed. However, at least the support on which the photoenergy is irradiated must transmit photoenergy.

In the recording method of the present invention, the relationship in greatness between the adhesive force of the image forming layer 7 onto the first support 5 and the adhesive force onto the second support 6 is designed to be reversed by curing of the image forming layer 7. That is, the adhesive forces of the image forming layer to the first support 5 and to the second support 6 before imparting light and heat energies are now defined as F₁ and F₂, respectively, and F₁ is changed to F'₁ and F₂ to F'₂ by imparting light and heat energies, it is controlled such that F₁ < F₂ (or F₁ > F₂) may become F'₁ > F'₂ (or F'₁ < F'₂) after light and heat energies are imparted.

Accordingly, after the relationship became F'₁ > F'₂, if the first support 5 is separated from the second support 6, the image forming layer 7 to which the above energies are not imparted remain on the second support 6, and the portion to which the above energies are imparted remain on the first support 5. Thus, on the supports 5 and 6 are formed recorded images which are exactly in the relationship of negative image and positive image. The case is the same when F₁ > F₂ becomes F'₁ < F'₂.

Further, by conveying the image obtained on the second support with the second support superposed on the transfer-recording medium 100 between the rollers 101 and 102 as shown in Fig. 3, it can be transferred onto the transfer-recording medium 100 such as paper etc. In this case, by conveying the first support 5 superposed on the transfer-recording medium 100 between the rollers 101 and 102, it is also possible to obtain the reversal image of the above. Also, the rollers 101 and 102 may be made heatable, if necessary.

As the means for reversing the greatness relationship of the adhesive forces F₁ and F2 as described above, the first support 5 and the second support 6 may be made different from each other, or alternatively when the same kind of support is used, either one of the supports may be applied with working so as to satisfy the above greatness relationship of the adhesive forces.

Next, description is made about the method for forming multi-color recorded image.

Fig. 4 is a recording medium to be used for multi-color image formation, and the image forming layer 37 comprises a distributed layer of image forming elements 37a, 37b and 37c with different tones from each other, which are cured by imparting light and heat energies similarly as in the example shown in Fig. 2 to be changed in adhesive forces to the first support 5 and the second support 6. The image forming elements 37a, 37b, 37c respectively contain either one colorant component of yellow (Y), magenta (M) and cyan (C). However, the colorant component contained in each of the image forming elements 37a, 37b and 37c is not limited to yellow, magenta and cyan, but any colorant material may be used depending on the use. Also, the kinds of the colorant components may be two, or four or five. The distribution of the image forming elements 37a, 37b and 37c is not required to be arranged regularly, provided that it is uniform to some extent. Further, the shape of the image forming elements 37a, 37b and 37c may be any desired one. For example, it may be one formed by natural deformation when fine particulate image forming elements 37a, 37b and 37c are sandwiched between the supports 5 and 6.

The image forming elements 37a, 37b and 37c have wavelength selectivity depending on the colorant components contained therein. More specifically, the reaction of the image forming element 37a containing a yellow colorant component will proceed abruptly to effect the curing, when heat and a light with wavelength λ1 are applied. And, when a light with wavelength other than λ1 is applied, no reaction will proceed. Similarly, the reaction of the the image forming element 37b containing a magenta colorant component proceeds when heat and a light with wavelength of λ2 are applied and the reaction of the image forming element 37c containing a cyan colorant component proceeds when heat and a light with wavelength λ3 are applied to effect the curing.

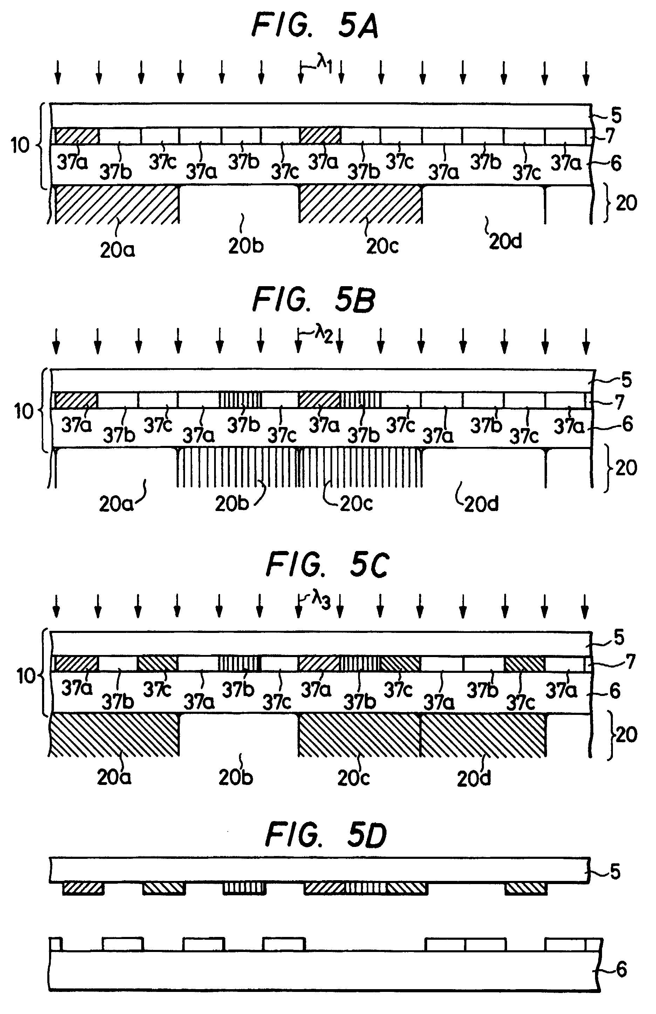

Fig. 5A through 5C illustrate partially the relationship between the recording medium and the thermal head 20, in which the heat energy modulated according to recording signals is imparted together with the light energy with the wavelength selected according to the tone of the image forming element which is desired to be cured. "Modulation" means to change the position at which the energy is imparted corresponding to the image signal.

Now, according to the image forming method of the present invention, the recording medium 10 is superposed on the thermal head 20 and irradiated with light so as to cover the whole region of the heat generating portion of the thermal head 20. At this time, the recording medium 10 is superposed on the thermal head 20 so that the support 5 may be the irradiated surface. As the light to be irradiated, those with wavelengths with which the image forming elements are reactive are successively irradiated. For example, when the image forming elements exhibit tones of either yellow, magenta or cyan, lights with wavelengths λ1, λ2 and λ3 are successively irradiated.

Shortly speaking, first the light with wavelength λ1 is irradiated from the support 5 side of the recording medium 10, and, for example, the heat generating resistors 20a, 20c of the thermal head 20 are subjected to heat generation. Then, of the image forming elements 37a exhibiting yellow, the image forming elements applied with both heat and the light with wavelength λ1 are cured.

Next, as shown in Fig. 5B, the image forming layer 7 is irradiated with the light with wavelength λ2, and also the heat generating resistors 20b, 20c are subjected to heat generation, whereby of the image forming elements 37b exhibiting magenta color, image forming elements applied with heat and the light with wavelength λ2 are cured. Further, as shown in Fig. 5C, by heat generation of the heat generating resistors simultaneously with irradiation of the light with wavelength λ3, the image forming elements applied with light and heat are cured.

By separating the support 5 of the recording medium thus obtained from the support 6, the cured image forming elements remain on the support 5 and uncured image forming elements on the support 6 as shown in Fig. 5D.

Further, as described with reference to Fig. 3, by transferring the support 5 or the support 6 separated onto the transfer-receiving medium 100, a multi-color image can be obtained on any kind of sheet.

In the example as described above by referring to Fig. 5A - 5D, there is shown the method in which light is irradiated on the whole region of the thermal head 20 and an image is formed by selective heat generation of the heat generating resistors of the thermal head 20.

Also, in the above description, the image forming layer 7 is adhered strongly to the support 6 before curing, while adhered strongly to the support 5 after curing, but it is also possible to set the situation by selection of the support and the image forming layer such that the image forming layer is strongly adhered to the support 5 before curing, while adhered strongly to the support 6 by curing.

For reversing the greatness relationship of the adhesive forces F₁ and F₂ between the image forming layer and support by curing of the image forming layer, for example, the materials for the support 5 and the support 6 may be made different.

For example, when a polymer layer containing acrylamide is made the image forming layer, the combinations shown in the following Table may be considered.

| | First Support | Second support | Support with cured portion transferred | Support with uncured portion transferred |
|---|---|---|---|---|
| (a) | Polyethylene | Cellophane | Cellophane | Polyethylene |
| | | | | |
| (b) | Polyethylene | Tenguzyo paper | Tenguzyo paper | Polyethylene |
| | | | | |
| (c) | Cellophane | Offset master | Offset master | Cellophane |
| | | | | |
| (d) | Polyethylene | Spirit master paper | Polyethylene | Spirit master paper |

Also, when an acrylic monomer is made the image forming layer, by use of a polyethylene terephthalate (PET) film as the first support and a draft film as the second support, the cured portion can be transferred onto the PET film and the uncured portion onto the draft film.

Further, when urethane acrylate, etc. is made the image forming layer, by use of PET film or aromatic polyamide film as the first support and polypropylene film as the second support, the cured portion can be transferred onto the polypropylene film and the uncured portion onto the PET film or aromatic polyamide film.

Other than making the materials for the first support and the second support different, the greatness relationship of adhesive forces F₁ and F₂ can be reversed by applying working on either one of the supports, for example, provision of an adhesive material layer on one of the supports may be mentioned as an example. In this case, the adhesive material may be selected so as to satisfy the greatness relationship of adhesive forces as mentioned above. Particularly, it is desirable to set the adhesive force of the image forming layer to the adhesive material layer greater than that to the support on which no adhesive material layer is provided, under the state where none of light energy and heat energy is imparted. For example, when urethane acrylate, etc. is used as the image forming layer, a recording medium is prepared with the image forming layer being in contact with one of the supports through an epoxy type adhesive layer, while the image forming layer being in contact with the other support without providion of the adhesive layer. By doing so, the uncured portion is transferred onto the epoxy type adhesive side, and the cured portion onto the support where no adhesive layer is provided. When the image forming layer is constituted of a distributed layer of image forming elements, an adhesive layer may be provided on the support to be adhered to the image forming elements.

As described above, by selecting suitably the support corresponding to the kind of the image forming layer or by providing an adhesive layer on one of the supports, the greatness relationship of adhesive forces can be reversed.

The image forming layer to be used in the recording medium is cured through abrupt progress of the reaction by imparting both of light energy and heat energy. The phenomenon of the image forming layer is described below.

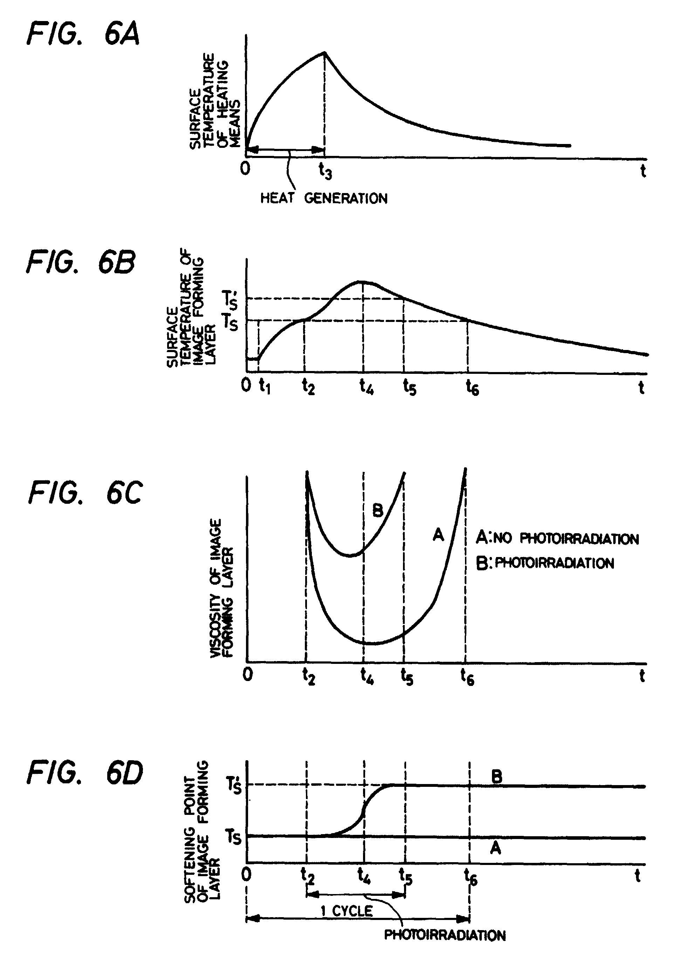

The time axis (axis of abscissa) of each graph in Figs. 6A - 6D corresponds to one another. Also, in the image forming layer, as described below, at least a photoinitiator and a monomer, an oligomer or a prepolymer having unsaturated double bond are contained. Fig. 6A shows how the surface temperature of the heating means is elevated when the heating means such as thermal head, etc. is driven for heat generation for the time of 0 - t₃ and thereafter dropped. The recording medium in pressure contact against the heating means will exhibit the temperature change as shown in Fig. 6B with the temperature change of the heating means, namely elevated in temperature with a time delay of t₁, reaches the maximum temperature at the time t₄ similarly with a delay after t₃, and thereafter dropped in temperature. The image forming layer has a softening temperature Ts, and will be abruptly softened at a temperature region of Ts or higher to be reduced in viscosity. This behaviour is shown by the curve A in Fig. 6C. After reaching Ts at the time t₂, viscosity drop continues up to the time t₄ where the maximum temperature is reached, and the viscosity will be again increased simultaneously with lowering in temperature, until abrupt viscosity increase will be exhibited to the time t₆ when the temperture is dropped to Ts. In this case, the physical properties of the image forming layer are basically the same as before heating.

However, in the case of the present invention, since light is irradiated simultaneously with heating at the time t₂, for example, a photoinitiator contained in the image forming layer is activated and, if the temperature is elevated sufficiently to make the reaction rate greater, the probability of polymerizing polymerizable monomer or oligomer becomes dramatically greater, whereby curing will abruptly proceed.

By effecting thus heating and photoirradiation, the image forming layer shows the behaviour as shown in the curve B in Fig. 6C. And, as the reaction proceeds, the softening temperature is elevated until it is changed from Ts to T's at the time t₅ when the reaction is completed. This behaviour is shown in Fig. 6D. Accordingly, in the subsequent separation step, there occurs change in the greatness relationship of adhesive forces to the support 5 and the support 6 between the portion changed to T's and the portion not changed, whereby an image is recorded.

As the physical properties controlling the change in greatness relationship of adhesive forces of the image forming layer to the support 5 and the support 6, other than the softening temperature as described above, melting temperature, glass transition point, etc. may be conceivable, but in either case, a recorded image is formed in the image forming layer by utilizing the irreversible change in melting temperature, softening temperature, etc. before and after imparting light energy and heat energy.

The image forming layer of the present invention contains at least a photoinitiator, a monomer, an oligomer or a prepolymer having unsaturated double bond, and can also incorporate additives such as binder, thermal polymerization inhibitor, plasticizer, colorant, surface lubricant, etc., if necessary.

As the photoinitiator to be used in the present invention, there are carbonyl compounds, halide compounds, azo compounds, organic sulfur compounds, including, for example, aromatic ketones and derivatives thereof such as acetophenone, benzophenone, coumarine, xanthone, thioxanthone, chalcone, styryl styryl ketone, and the like; diketones and derivatives thereof such as benzyl, acenaphtlenequinone, camphorquinone and the like; halide compounds such as anthraquinone sulfonyl chloride, quinoline sulfonyl chloride, 2,4,6-tris(trichloromethyl)-S-triazineand the like, but the present invention is not limited thereto.

Also, when multi-color recording is performed according to the image forming method of the present invention, the image forming elements constituting the image forming layer are required to have wavelength selectivity depending on the colorants contained. In short, when the image forming layer is constituted of image forming elements of n kinds of colors, the distributed layer of the image forming elements is constituted with 1 combination of photoinitiators which will abruptly change the reaction rates with lights with different wavelengths, namely with n kinds of different wavelengths for the respective colors. As such combination of photoinitiators, there may be employed the following combinations.

The photoinitiator using 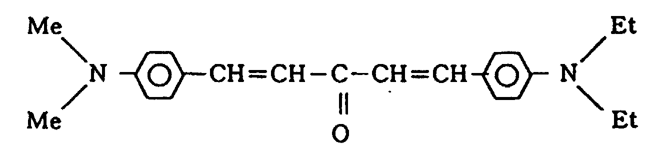 or 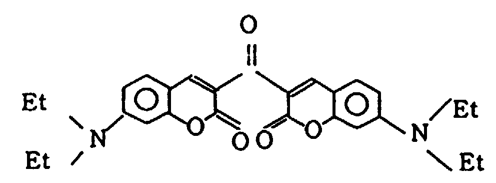 in combination with S-triazine having trihalomethyl group has the maximum sensitivity at around 430 - 500 nm.

On the other hand, the photoinitiator using 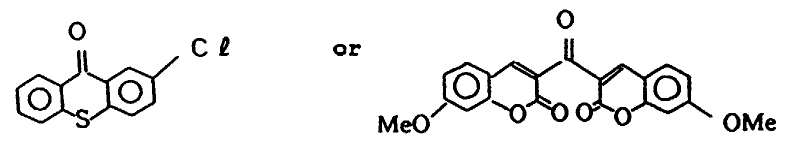 in combination with a tertiary amine has the maximum sensitivity at around 370 - 400 nm.

Further, the photoinitiators using 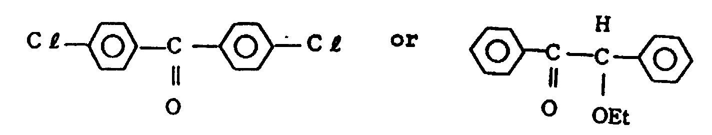 in combination with a tertiary amine has the maximum sensitivity at around 300 - 350 nm.

As described above, by making the maximum sensitivity region of the photoinitiator different, the image forming element can have wavelength selectivity. Accordingly, by use of the above photoinitiators, it becomes possible to effect color separation of 3 colors. Further, development to full color recording becomes possible. Also, in the present invention, by using a compound having great absorption from UV to visible region such as UV-ray absorbers in combination with the photoinitiator, the photosensitive wavelength region of the photoinitiator can be also narrowed to enhance spectral characteristics of the photoinitiator.

The monomer, oligomer or prepolymer having unsaturated double bond to be used in the present invention may include urethane acrylates or urethane methacrylates synthesized by the polyaddition reaction of polyisocyanates (which may be optionally reacted with polyols) and alcohols, amines containing unsaturted double bond; epoxy acrylates synthesized by the addition reaction of epoxy resins and acrylic acid or methacryic acid; or polyester acrylates; spinacrylates; polyether acrylates; etc., but the present invention is not limited to these.

Also, as the polymer, there may be included those having a skeleton of polyalkyl, polyether, polyester, polyurethane, etc. in the main chain and having introduced polymerizable or crosslinkable reactive groups, typically acrylic group, methacrylic group, cinnamoyl group, cinnamylideneacetyl group, furylacryloyl group, cinnamic ester, etc., but the present invention is not limited to these.

Also, the monomers, oligomers and prepolymers as mentioned above should desirably be solid at ordinary temperature.

The monomer, oligomer or prepolymer having unsaturated double bond and the photoinitiator may be used in combination with a binder. As the binder, there may be mentioned polyalkyl acrylates such as polymethyl acrylate, polyethyl acrylate and the like; polyalkyl methacrylates such as polymethyl methacrylate, polyethyl methacrylate and the like; methacrylic acid copolymers, acrylic acid copolymers, maleic acid copolymers; chlorinated polyolefins such as chlorinated polyethylene, chlorinated polypropylene and the like; polyvinyl chloride, polyvinylidene chloride, polyacrylonitrile or copolymers of these; polyvinyl alkyl ether, polyethylene, polypropylene, polystyrene, polyamide, polyurethane, chlorinated rubber, cellulose derivatives, polyvinyl alcohol, polyvinyl pyrrolidone, etc., but the present invention is not limited to these. These binders may be used either singly or as a mixture of two or more kinds at a suitable ratio. Also, as the binder, waxes which may be either compatible or noncompatible may be used.

The colorant is a component to be contained for forming an optically recognizable image, and various pigments and dyes can be suitably used. Examples of such pigments, dyes may include inorganic pigments such as carbon black, yellow lead, molybdenum red, iron oxide red, etc.; organic pigments such as Hansa Yellow, Benzidine Yellow, Brilliant Carmine 6B, Lake Red C, Permanent Red F5R, Phthalocyanine Blue, Victoria Blue Lake, Fast Sky Blue, etc.; leuco dyes, phthalocyanine dyes, etc.

The amount of the colorant may be preferably 0.1 to 30 parts by weight based on the total amount of the binder, the photoinitiator, the monomer, oligomer or prepolymer having unsaturated double bond.

Further, additives such as thermal polymerization inhibitors, plasticizers, etc. may be added, if necessary.

The monomer, oligomer or prepolymer having unsaturated double bond contained in the image forming layer may preferrably 10 to 99% by weight based on the weight of the image forming layer. The photoinitiator may be preferably 0.1 to 20% by weight based on the weight of the image forming layer, and the binder 0 to 90% by weight.

The image forming layer as described above may be a continuous layer obtained by dissolving the materials in a solvent and coating the resultant solution, or the image forming layer may be provided as the distributed layer of particulate image forming elements.

As the first support 5 and the second support 6 to be used for the recording medium those known in the art may be used. For example, there may be employed polyester, polyethylene, polyvinyl chloride, cellulose, polycarbonate, nylon, polyamide, polyimide; papers such as Tenguzyo paper, spirit carbon paper, offset master paper, etc.; further metals such as zinc, aluminum, etc. Among them, as the support which can transmit photoenergy, there can be employed films such as of polyester, polyethylene, polyvinyl chloride, cellulose, polycarbonate, nylon, polyamide, polyimide, etc.

The first support 5 and the second support 6 may have a thickness which may be determined in view of separation of a pair of supports. For example, either one of the first support 5 and the second support 6 should preferably have a thickness ranging from 1 to 50 µm, preferably from 3 to 20 um.

On the surface of the support, for making the change in adhesive force to the image forming layer easier, a coated layer can be also provided, if necessary. Also, a halation preventive layer, a UV-ray absorbing layer or a visible light absorbing layer may be provided.

The image forming layer should preferably have a thickness of 1 to 20 µ, particularly 3 to 10 µ. When the image forming layer comprises a distributed layer of particulate image forming elements, the particle size of the element should be preferably 1 to 20 µ, particularly 3 to 15 µ. Also, the particle size distribution of the elements should be preferably ± 50% or below, particularly ± 20% or below, relative to the number average particle size.

As the method for preparing the recording medium a mixture of the components constituting the Image forming layer mixed and melted with a suitable solvent is applied on one of the supports and after drying of the solvent, adhered onto another support. In carrying out this operation, uniform adhering can be effected by passing through two pressure contacted rollers. Also, it is effective to heat the above rollers, if necessary.

On the other hand, when the image forming layer consists of a distributed layer of fine image forming elements, a melt mixture of the components constituting the image forming elements is particulated by spray drying, etc. to obtain first fine image forming elements, and then the image forming elements obtained are attached on the adhesive layer provided on one of the supports. For the adhesive layer, one generally used as the adhesive such as poyvinyl alcohol, epoxy type, urethane type adhesives can be applied as such. Finally, the composite having the image forming elements attached thereon can be plastered on another support to obtain the recording medium.

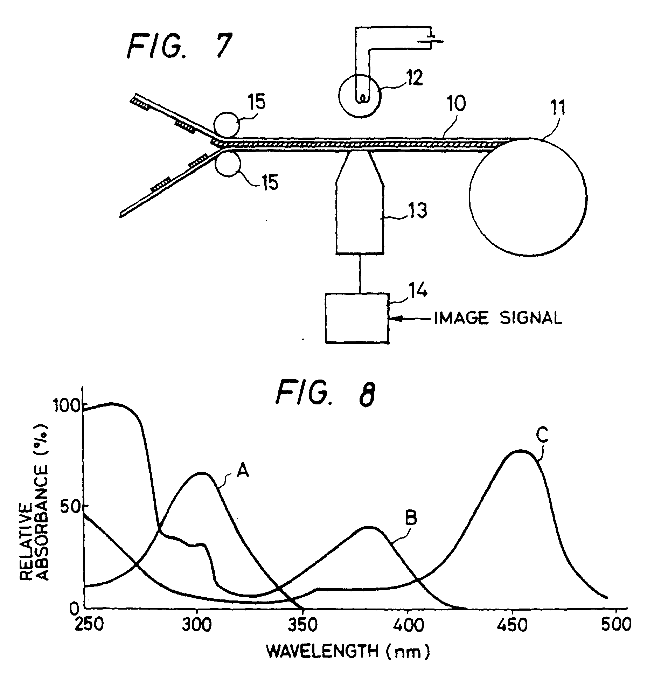

Fig. 7 is a schematic illustration showing an example of the device for practicing the image forming method. 10 is the recording medium of the present invention, 11 the feed roll having the recording medium wound therearound, 12 the light irradiation means for irradiating uniformly photoenergy on the recording medium 10 and, for example, low pressure mercury lamp, high pressure mercury lamp, metal halide, fluorescent lamp, xenon lamp, etc. can be used. 13 is the heating means such as thermal head, etc. for generating heat pulses from the control circuit 14 based on image signals. The heating means 13 is provided with a plurality of heating elements. The heating elements may be arranged in one array or a plurality of arrays, or arranged in a matrix. Also, the heating elements may be separated from each other, or alternatively comprise a continuous rod-shaped current passage heat generating material separated with a plurality of electrodes. As the recording medium 10, it is also possible to use a recording medium of the current passage heat generation type in which heat is generated by current passage, and in this case the heating means 13 is a current passage head 1 or generating electrical pulses for current passage. 15 is an auxiliary roller for separating stably the first support and the second support constituting the recording medium 10.

Now, the recording medium 10 delivered out from the the feed roll 11 is given the heat pulses based on image signals from the thermal head 13. On the other hand, from the lamp 12, lights with different wavelengths are irradiated successively and synchronized with heat pulses based on the image signals. The principle of the transfer image forming step is as described by referring to Fig. 5A - 5C. The lamp 12 in Fig. 7 is schematically shown, and it is preferable to irradiate lights with different wavelengths from a plurality of lamps. Thai is, if a light with one wavelength is irradiated by one lamp, the same number of lamps as the kinds of the tones exhibited by the image forming elements are required. Thus, by the thermal head 13 and the lamp 12, a recorded image is formed on the image forming layer, and then by separating the first support from the second support by the auxiliary roller 15, the recorded image can be obtained on the respective supports.

Having described about formation of multi-color image, formation of mono-color image is also possible by means of the device shown in Fig. 7 by use of one kind of photoinitiator.

Also, the devices shown in Fig. 7 form recorded images on the support, but it is also possible to provide a pair of rollers, etc. as the transfer means and obtain images on a transfer-receiving medium by transfer of the recorded images on the support thereon.

Further, as a mode of the image forming method of the present invention, it is also possible to make the steps for formation of the image, namely the light irradiation means and the heating means one unit and form images with arrangement of plural arrays of said unit. In this case, the device can be an advantageous means in effecting speed-up of the process.

The image forming method of the present invention can be also used for preparation of a plate to be used for printing, etc.

The present invention is described in more detail by referring to the following Examples.

### Example 1

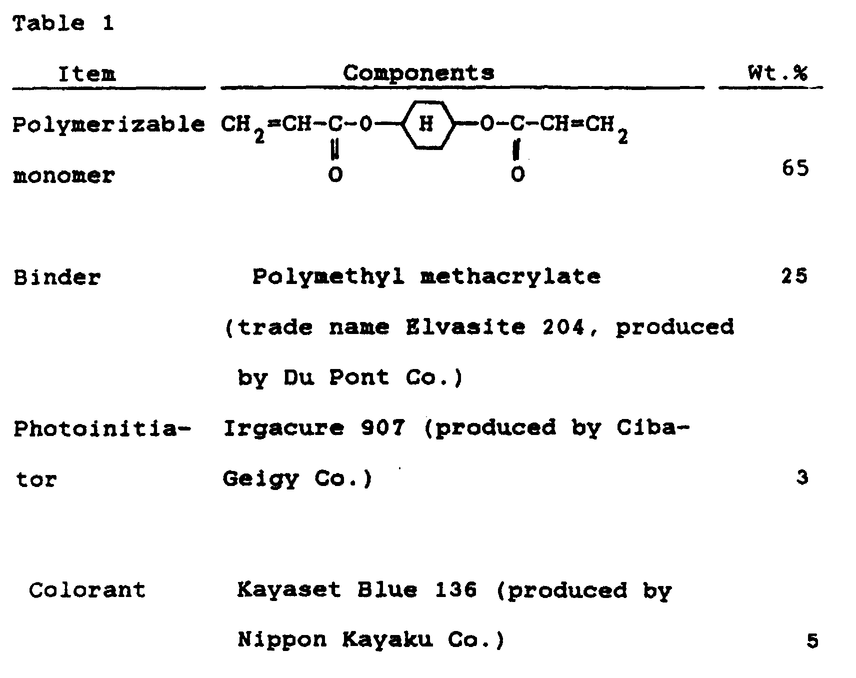

The components shown in Table 1 were mixed with a methylene chloride solvent and solvent coated on a PET film with a thickness of 6 µm to form an image forming layer. The image forming layer after drying of the solvent had a thickness of 8 µm. Next, with the image forming layer being superposed on a polypropylene film with a thickness of 100 µm, both were passed through two rollers contacting each other under a contact pressure of 1 Kg/cm² to have the PET film secured onto the image forming layer. The two rollers were maintained at surface temperature of 90 °C.

Now, the recording medium was wound in a roll and assembled in a device as shown in Fig. 7 so that the PET film may be the irradiated surface. As the thermal head 13, the line type of A-4 size with 8 dots/mm having a heat generating element array arranged at the edge portion, and pressed against the heat-generating elements through the tension of the recording medium 10. And, at the site opposed to the thermal head 13, a fluorescent lamp FL10A70E31/33T15 produced by Matsushita Electric Industrial Co., Ltd. was arranged. The fluorescent lamp had a peak wavelength of 313 nm.

Next, corresponding to image signals, heat generation of the thermal head was controlled. The current passage energy during heat generation was made 0.5 w/dot × 3 msec. Thus, while effecting photoirradiation with the fluorescent lamp 12 uniformly, the thermal head was controlled and driven according to the image signals, and by synchronization at a repeated period of 10 m sec./line, the recording medium 10 was conveyed with a stepping motor and a drive roll not shown. And, when the PET film was separated from the polypropylene film by means of the auxiliary roller 15, a desired image exhibiting blue color could be obtained on the polypropylene film. Also, on the PET, the reversal image of the image obtained on the polypropylene film remained.

On other hand, when the support of the recording medium was separated without imparting the photoenergy and the heat energy, the image forming layer remained on the PET.

### Example 2

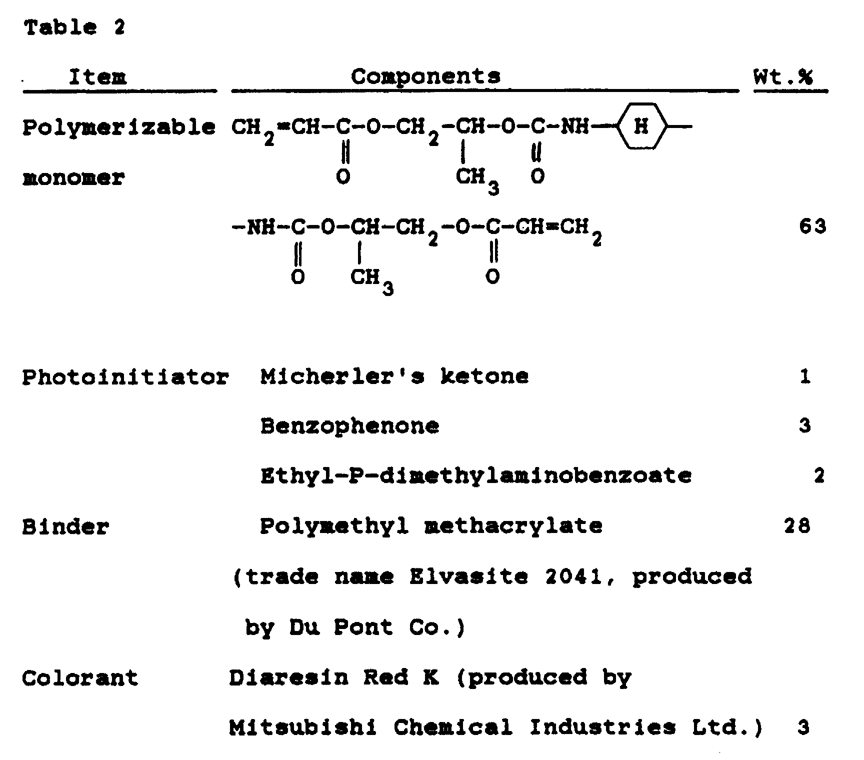

The components shown in Table 2 were formed between the polypropylene film and the PET film similarly as described in Example 1. The same polypropylene film and PET film as used in Example 1 were used and the image forming layer had a thickness of 6 µm.

Now, by use of the recording medium thus obtained, the image making experiment was practiced in the same manner as in Example 1, and consequently a desired image exhibiting red color could be obtained on the polypropylene. Also, on the PET, the reversal image of the image obtained on the polypropylene film was obtained. As the light source, corresponding to the absorption characteristics of the photoinitiator, a fluorescent lamp FLR16A70-BA37/33T16 (emission peak wavelength: 370 nm, supplied by Matsushita Electric Industrial Co., Ltd.) was used.

On the other hand, when the polypropylene film and the PET film of the recording medium were separated without imparting the photoenergy, the image forming layer remained on the PET film.

### Example 3

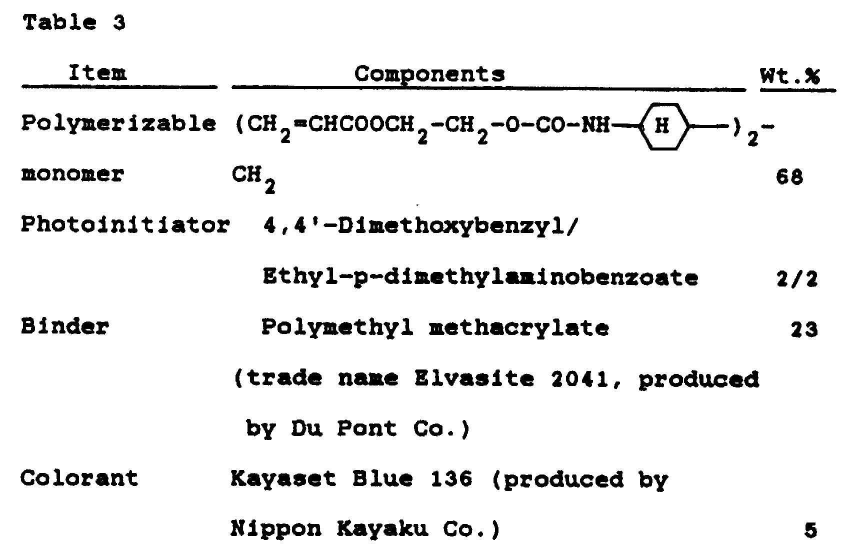

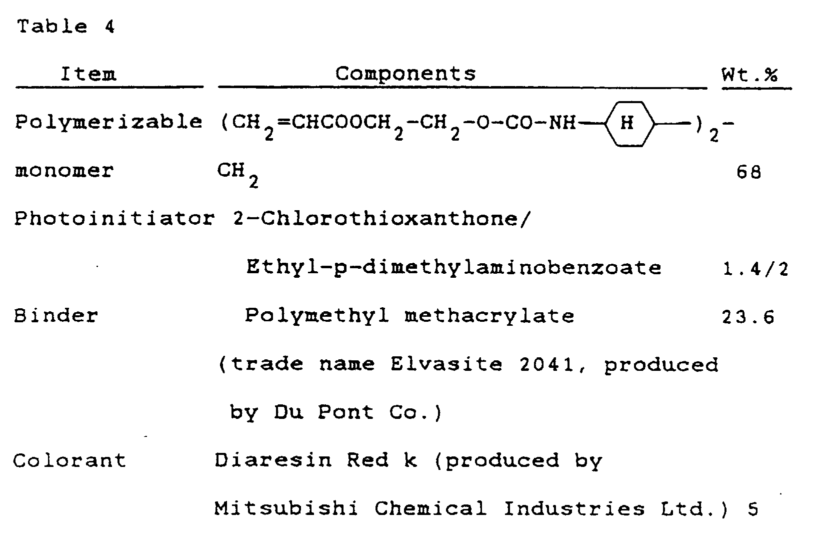

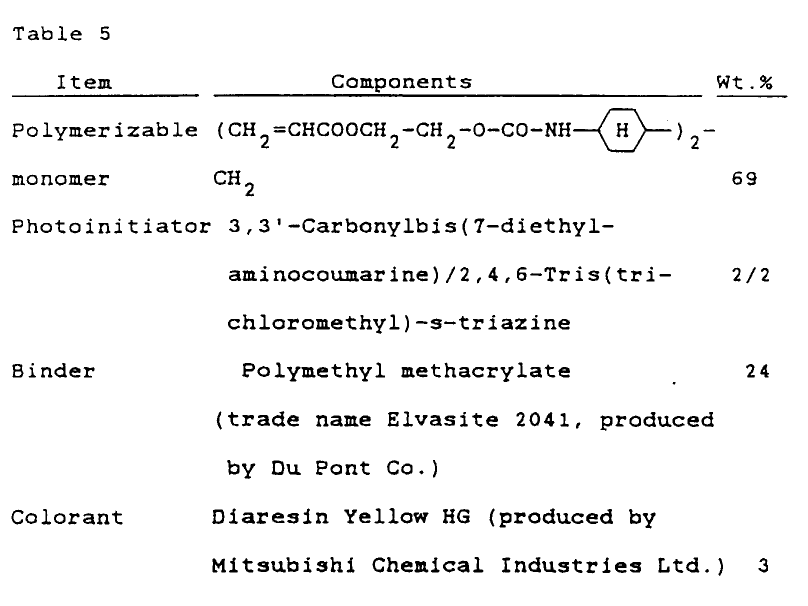

The components shown in Table 3, Table 4, and Table 5 were respectively mixed with methylene chloride solvent to prepare three kinds of particulate image forming elements according to the spray drying method. The particle size of image forming elements prepared was substantially within the range of 8 to 12 µm. The photoinitiators in the image forming elements shown in Table 3 initiate the reaction by absorption of the light in the band region of the graph A in the absorption characteristics shown in Fig. 8; the photoinitiators in the image forming elements shown in Table 4 initiate the reaction by absorption of the light in the band region of the graph B; and the photoinitiators in the image forming elements shown in Table 5 initiate the reaction by absorption of the light in the band region of the graph C. The colors of the color image forming elements were cyan, magenta and yellow.

By use of a mixture comprising equal amounts of the above three kinds of image forming elements, a recording medium was prepared by the method shown below.

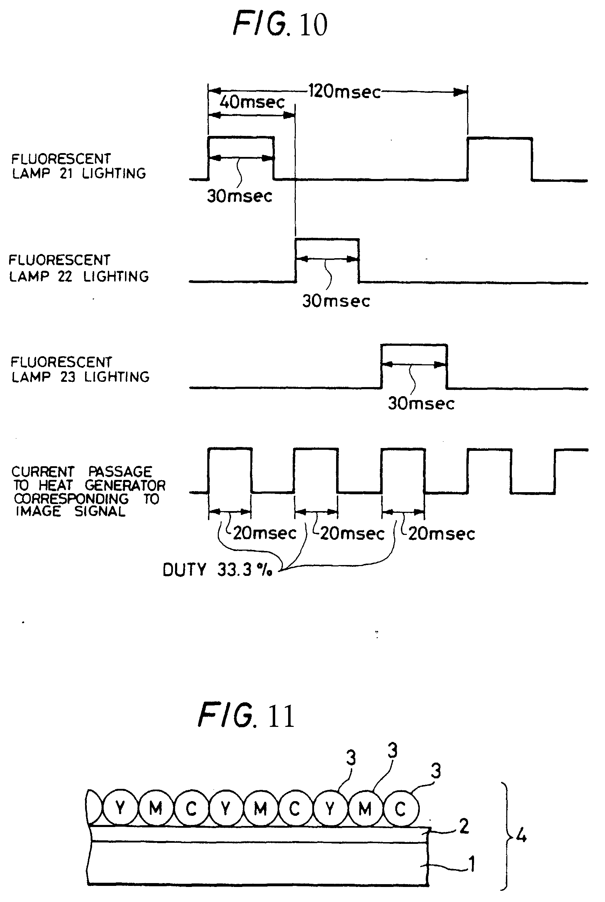

First, by use of a PET film with a thickness of 6 um as the second support 6, a toluene solution of Polyester LP-022 which is a polyester type adhesive produced by Nippon Synthetic Chemical Industry Co., Ltd. was applied on the PET film to a thickness after drying of about 1 um. On the adhesive material coated and dried, an excessive amount of the mixture of the three kinds of the image forming elements obtained above was sprayed. After removal of the image forming elements uncontacted with the adhesive material by using an air gun, a PET film with a thickness of 6 µm was superposed as the first support 5 so as to be in contact with the image forming elements, and passed through the two rollers contacted with each other under a pressure of 1 Kg/cm². The two rollers were maintained at a surface temperature of 40 °C. When the recording medium was separateiy subjected to separation between the first support and the second support, the image forming elements remained on the second support. The thus obtained recording medium was wound and assembled in the device shown in Fig. 10 with the first support side being the light irradiation surface.

In the present Example, as the light source 21, a 20W fluorescent lamp FL20SE for healthy rays produced by Toshiba K.K. with a peak wavelength of 335 nm was used; as the light source 22, a 20W fluorescent lamp FL10A70 E390 produced by Toshiba K.K. with a peak wavelength of 390 nm; and as the light source 23, a 20W fluorescent lamp FL10A70B produced by Toshiba K.K. with a peak wavelength of 450nm, respectively. As the thermal head 20, the same head as in Example 1 was employed, and as the current passage pulse during heat generation, 0.5 w/dot was applied at Duty 33.3% for atime of 20 msec.

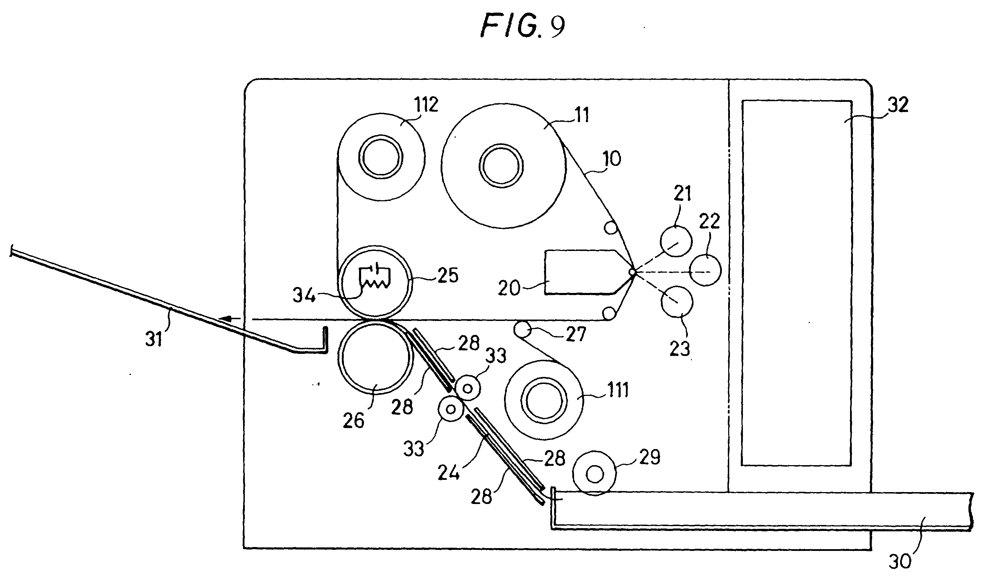

In Fig. 9, 10 is a feed roll for the recording medium 10, 111, 112 are respectively recovery rolls for the first support and the second support, 24 is a recording paper (plain paper), 30 is a recording paper casette, 25 is a transfer roller and 26 is a pressure roller. 32 is a control section for drive control of the present device.

By use of the device as described, images were formed as follows.

First, simultaneously with current passage through the thermal head 20 corresponding to image signals of cyan, the light from the fluorescent lamp 21 was uniformly irradiated. As shown in the timing chart in Fig. 10, the irradiation time was made 30 msec. After completion of the irradiation, after lapse of 10 msec., as shown in Fig. 10, current passage through the thermal head 20 corresponding to the image signals of magenta and uniform light irradiation from the fluorescent lamp 22 were effected. The current passage time and the irradiation time at this time were made the same as in the case of cyan. Further, for yellow image signals, the same procedure was repeated, and the recording medium 10 was conveyed by a stepping motor not shown and a transfer roller 25 as synchronized with the repeating period of 120 msec./line. And, after the first support was separated from the second support by the separation roller 27, the first support was wound up by the recovery roller 111, and the second support was superposed on the recording paper 24 delivered out from the recording paper casette 30 passing through the guide 28 by means of the paper feeding roller 29 and the conveying roller 33, and delivered to the pressure contact section of the transfer roller 25 and the pressure roller 26. The transfer roller 25 comprises an aluminum roller and is controlled by heating to a surface temperature of 90 °C by a built-in heater 34. As the pressure roller 26, an aluminum roller coated with silicone rubber was used. The contact pressure between the transfer roller 25 and the pressure roller 26 was made 25 Kg/cm².

When the second support and the recording paper 24 as overlapped on one another were passed between the two rollers 25, 26, the multi-color image on the second support was transferred onto the recording paper 24, and discharged in the discharging tray 31. The multi-color image on the recording paper thus obtained was free from color slippage, and yet high in chromaticity and sharp to give an image of high quality with good fixability.

As described above, in the present invention, since a photoenergy and a heat energy are employed for image formation, as compared with the method for using a recording medium in which only heat is used for obtaining the influence of the environmental temperature or characteristic change is obtained only by photoenergy as in the prior art methods, stability against environment becomes higher, whereby it is rendered possible to obtain constantly stable and highly precise images. Further, for this reason, storability of the recording medium and storability of recorded images were improved.

Also, as contrasted to the method by using only heat in which the recording speed is controlled by heat response or the prior art method which required great time on account of giving necessary energy for image formation with only one energy, the present invention is suited for high speed recording for controlling with a plurality of energies.

## Claims

1. An image forming method, which comprises using a recording medium having an image forming layer sandwiched between a first support and a second support, simultaneously imparting a photoenergy and a heat energy to said image forming layer the photoenergy being from a light irradiation means and the heat energy being from a heating means separate from the light irradiation means, and with said heat energy corresponding to an image signal and thereafter separating said first support from said second support, thereby forming a recorded image on said first support or said second support.

2. An image forming method according to Claim 1, wherein said image forming layer is constituted of plural kinds of image forming elements and said photoenergies with different wavelengths are imparted successively corresponding to the kinds of the colorants contained in said image forming elements.

3. An image forming method according to claim 1 further comprising the step of transferring said recorded image formed on said first support or said second support onto a transfer-receiving medium.

4. An image forming method according to Claim 3, wherein said image forming layer is constituted of plural kinds of image forming elements and said photoenergies with different wavelengths are imparted successively corresponding to the kinds of the colorants contained in said image forming elements.

## Patentansprüche

1. Verfahren zur Bilderzeugung, umfassend die Verwendung eines Aufzeichnungsmediums mit einer zwischen einem ersten Träger und einem zweiten Träger eingeschobenen Bilderzeugungsschicht, wobei gleichzeitig Photoenergie und Wärmeenergie auf die Bilderzeugungsschicht übertragen wird, und die Photoenergie von einer Belichtungseinrichtung und die Wärmeenergie von einer von der Belichtungseinrichtung getrennten Heizeinrichtung stammt, und die Wärmeenergie einem Bildsignal entspricht, wobei der erste Träger danach von dem zweiten Träger getrennt wird, wodurch auf dem ersten Träger oder auf dem zweiten Träger ein aufgezeichnetes Bild erzeugt wird.

2. Verfahren zur Bilderzeugung nach Anspruch 1, wobei die Bilderzeugungsschicht aus mehreren Arten von Bilderzeugungselementen aufgebaut ist und Photoenergien mit verschiedenen Wellenlängen entsprechend den Arten der in den Bilderzeugungselementen enthaltenen Färbemitteln nacheinander übertragen werden.

3. Verfahren zur Bilderzeugung nach Anspruch 1, das ferner den Schritt der Übertragung des aufgezeichneten, auf dem ersten Träger oder dem zweiten Träger erzeugten Bildes auf ein Übertragungs-Aufnahmemedium umfaßt.

4. Verfahren zur Bilderzeugung nach Anspruch 3, wobei die Bilderzeugungsschicht aus mehreren Arten von Bilderzeugungselementen aufgebaut ist und Photoenergien mit verschiedenen Wellenlängen entsprechend den Arten der in den Bilderzeugungselementen enthaltenen Färbemitteln nacheinander übertragen werden.

## Revendications

1. Procédé de formation d'image, qui comprend l'utilisation d'un support d'enregistrement possédant une couche de formation d'image intercalée entre un premier support et un second support, la transmission simultanée d'une énergie photoélectrique et d'une énergie thermique à ladite couche de formation d'image, l'énergie photoélectrique provenant d'un moyen de photo-irradiation et l'énergie thermique provenant d'un moyen de chauffage séparé du moyen de photo-irradiation, et ladite énergie thermique correspondant à un signal d'image, puis la séparation dudit premier support dudit second support, ce qui provoque la formation d'une image enregistrée sur ledit premier support ou ledit second support.

2. Procédé de formation d'image suivant la revendication 1, dans lequel la couche de formation d'image est constituée de plusieurs types d'éléments de formation d'image et les énergies photoélectriques ayant des longueurs d'ondes différentes sont transmises successivement en fonction des types des colorants présents dans lesdits éléments de formation d'image.

3. Procédé de formation d'image suivant la revendication 1 comprenant en outre l'étape de transfert de l'image enregistrée formée sur le premier support ou le second support sur un milieu récepteur de transfert.

4. Procédé de formation d'image suivant la revendication 3, dans lequel la couche de formation d'image est constituée de plusieurs types d'éléments de formation d'image et les énergies photoélectriques ayant des longueurs d'ondes différentes sont transmises successivement en fonction des types des colorants présents dans lesdits éléments de formation d'image.
